# EUROPEAN PATENT APPLICATION

(11) **EP 4 471 191 A1**
(43) Date of publication of application: **04.12.2024**
(21) Application number: 23747016.6
(22) Date of filing: 26.01.2023
(51) Int. Cl.: C30B 29/16, C30B 23/02, H01L 21/314, H01L 21/316, H10N 30/06, H10N 30/076, H10N 30/079, H10N 30/853, H10N 30/87

(54) **MULTILAYER STRUCTURE, ELECTRONIC DEVICE, ELECTRONIC APPARATUS AND MANUFACTURING METHOD FOR SAME**

(30) Priority: 27.01.2022 JP 2022011344; 31.08.2022 JP 2022138833
(71) Applicant: Gaianixx Inc., Tokyo, 113-0033 (JP)
(72) Inventor: KIJIMA, Takeshi, Tokyo 103-0014 (JP)
(74) Representative: Gille Hrabal Partnerschaftsgesellschaft mbB Patentanwälte
(86) International application number: PCT/JP2023/002397
(87) International publication number: WO 2023/145806

(57) **Abstract**

Provided are a laminated structure including an epitaxial film having good adhesion and crystallinity, an electronic device, an electronic apparatus, and a manufacturing method that can provide the same in an industrially advantageous manner.

In a method for manufacturing a laminated structure in which an epitaxial layer is laminated on a crystal substrate with at least a compound film interposed therebetween, the lamination is performed by a step of providing a compound element supply sacrificial layer containing a compound element on the crystal substrate and a step of forming the epitaxial layer using the compound element of the compound element supply sacrificial layer.

## Description

### Technical Field

The present invention relates to a laminated structure including an epitaxial film, an electronic device, an electronic apparatus, and a method for manufacturing the same.

### Background Art

A thin film made of lead zirconate titanate (Pb(Zr,Ti)O3) (hereinafter also referred to as PZT) having excellent piezoelectricity and ferroelectricity utilizes its ferroelectricity, and is applied to memory elements such as a nonvolatile memory (FeRAM), and a micro electro mechanical system (MEMS) technology such as an inkjet head and an acceleration sensor.

In recent years, it has been studied to form a piezoelectric film having good piezoelectric characteristics on a Pt film by forming the Pt film oriented in (200) on a Si substrate oriented in (100) via a ZrO₂ film or the like oriented in (200) (Patent Literature 1). However, adhesion and crystallinity at an interface are still not satisfactory, and measures that can improve the adhesion and crystallinity at the interface and further improve the piezoelectric characteristics of the piezoelectric film have been desired.

### Citation List

### Patent Literature

Patent Literature 1: JP 2015-154015 A

### Summary of Invention

### Technical Problem

An object of the present invention is to provide a laminated structure including an epitaxial film having good adhesion and crystallinity, an electronic device, an electronic apparatus, and a manufacturing method that can provide the same in an industrially advantageous manner.

### Solution to Problem

As a result of intensive studies to achieve the above object, the present inventors have found that a laminated structure including an epitaxial film having excellent adhesion and crystallinity can be easily obtained even with different compositions by a method for manufacturing a laminated structure in which an epitaxial layer containing a crystalline compound is laminated on a crystal substrate, in which the lamination is performed by a step of providing a compound element supply sacrificial layer containing a compound element on the crystal substrate and a step of forming the epitaxial layer using the compound element of the compound element supply sacrificial layer, and the present inventors have found that such a laminated structure and a method for manufacturing the same can solve the above-described conventional problems at once.

Further, the present inventors have completed the present invention by further conducting studies after obtaining the above knowledge.

In other words, the present invention relates to the following inventions.
[1] A method for manufacturing a laminated structure in which an epitaxial layer containing a crystalline compound is laminated on a crystal substrate, the manufacturing method including a step of providing a compound element supply sacrificial layer containing oxygen on the crystal substrate, and a step of forming the epitaxial layer using the compound element of the compound element supply sacrificial layer.
[2] The manufacturing method according to [1], in which after the compound element is used, a compound element gas is introduced to form the epitaxial layer in the presence of the compound element gas.
[3] The manufacturing method according to claim 1 or 2, in which the lamination is performed by vapor deposition or sputtering.
[4] The manufacturing method according to [1] or [2], in which the lamination is performed by vapor deposition.
[5] The manufacturing method according to any one of [1] to [4], in which the compound element supply sacrificial layer is a compound film provided on the crystal substrate.
[6] A laminated structure in which an epitaxial layer is laminated on a crystal substrate, characterized in that the epitaxial layer is formed by incorporating a compound element in a compound element supply sacrificial layer that is provided on the crystal substrate and contains the compound element.
[7] The laminated structure according to [6], in which the crystal substrate is a crystalline Si substrate.
[8] The laminated structure according to [6] or [7], in which the compound element supply sacrificial layer includes a compound film.
[9] The laminated structure according to [8], in which a film thickness of the compound film is more than 1 nm and less than 100 nm.
[10] The laminated structure according to any one of [6] to [9], in which the epitaxial layer contains a metal.
[11] The laminated structure according to [10], in which the metal contains a periodic table d-block metal.
[12] The laminated structure according to any one of [6] to [9], in which the epitaxial layer contains a metal compound.
[13] The laminated structure according to any one of [6] to [9], in which the epitaxial layer includes a dielectric.
[14] The laminated structure according to any one of [6] to [13], in which a second epitaxial layer having a composition different from that of the epitaxial layer is further laminated on the epitaxial layer directly or via another layer.
[15] The laminated structure according to [14], in which the epitaxial layer includes a dielectric, and the second epitaxial layer includes a single crystal film of a conductive metal.
[16] The laminated structure according to [14] or [15], in which a third epitaxial layer having a composition different from those of the epitaxial layer and the second epitaxial layer is further laminated on the second epitaxial layer directly or via another layer.
[17] The laminated structure according to [16], in which the third epitaxial layer includes a dielectric, a semiconductor, or a conductor.
[18] The laminated structure according to [16], in which the third epitaxial layer includes a dielectric.
[19] The laminated structure according to [16], in which the third epitaxial layer includes a piezoelectric body.
[20] A piezoelectric element including a laminated structure, characterized in that the laminated structure is the laminated structure according to any one of [6] to [19] .
[21] A method for manufacturing a piezoelectric element that uses a laminated structure, characterized in that the laminated structure is the laminated structure according to any one of [6] to [19].
[22] An electronic device including a laminated structure, characterized in that the laminated structure is the laminated structure according to any one of [1] to [14] .
[23] The electronic device according to [22], in which the electronic device is a piezoelectric device.
[24] A method for manufacturing an electronic device that uses a laminated structure, characterized in that the laminated structure is the laminated structure according to any one of [6] to [19].
[25] An electronic apparatus including an electronic device, characterized in that the electronic device is the electronic device according to [22] or [23].
[26] A method for manufacturing an electronic apparatus using a laminated structure or an electronic device, characterized in that the laminated structure is the laminated structure according to any one of [6] to [19], and the electronic device is the electronic device according to [22] or [23].
[27] A system including an electronic apparatus, characterized in that the electronic apparatus is the electronic apparatus according to [25].
[28] A laminated structure in which an epitaxial layer is laminated on a crystal substrate, the laminated structure including an amorphous thin film containing a constituent metal of the epitaxial layer and/or the crystal substrate and/or one or more embedded layers that are embedded in a part of the crystal substrate and contain the constituent metal, between the crystal substrate and the epitaxial layer.
[29] The laminated structure according to [28], including an amorphous thin film containing a constituent metal of the epitaxial layer and/or one or more embedded layers that are embedded in a part of the crystal substrate and contain a constituent metal of the epitaxial layer, between the crystal substrate and the epitaxial layer.
[30] The laminated structure according to [28], including an amorphous thin film containing a constituent metal of the epitaxial layer and/or the crystal substrate and one or more embedded layers that are embedded in a part of the crystal substrate and contain the constituent metal, between the crystal substrate and the epitaxial layer.
[31] The laminated structure according to any one of [28] to [30], in which the constituent metal contains Hf.
[32] The laminated structure according to any one of [28] to [31], in which the amorphous thin film has a film thickness of 1 nm to 10 nm.
[33] The laminated structure according to any one of [28] to [32], in which the shape of the embedded layer has a substantially inverted triangular cross-sectional shape.
[34] An electronic device, an electronic apparatus, or a system including a laminated structure, characterized in that the laminated structure is the laminated structure according to any one of [28] to [33].

### Advantageous Effects of Invention

The laminated structure, the electronic device, and the electronic apparatus of the present invention include an epitaxial film having good adhesion and crystallinity, and the manufacturing method of the present invention has an effect that the laminated structure, the electronic device, and the electronic apparatus can be obtained in an industrially advantageous manner.

### Brief Description of Drawings

Fig. 1 is a diagram schematically illustrating an example of a preferred embodiment of a laminated structure of the present invention.
Fig. 2 is a diagram schematically illustrating an example of another preferred embodiment of the laminated structure of the present invention.
Fig. 3 is a diagram schematically illustrating an example of an oxide film forming step of a preferred method for manufacturing a laminated structure of the present invention.
Fig. 4 is a diagram schematically illustrating an example of an epitaxial film forming step of a preferred method for manufacturing a laminated structure of the present invention.
Fig. 5 shows a cross-sectional STEM image observed in examples.
Fig. 6 shows a cross-sectional STEM image observed in examples.
Fig. 7 shows an STEM image observed in examples.
Fig. 8 shows an STEM image observed in examples.
Fig. 9 is a diagram schematically illustrating a preferred example of an embodiment of an MEMS transducer in the present invention.
Fig. 10 is a diagram schematically illustrating an example of a cross-sectional view of a part of a wafer equipped with a piezoelectric actuator, as a preferred application example of the present invention to a fluid discharge apparatus.
Fig. 11 is a diagram showing XPS measurement results in examples.
Fig. 12 is a diagram showing XPS measurement results in examples.
Fig. 13 is a diagram schematically illustrating a film forming apparatus suitably used in examples.
Fig. 14 shows a cross-sectional STEM image measured in examples.
Fig. 15 shows STEM images measured in examples.
Fig. 16 shows STEM images of an embedded layer measured in examples.

### Description of Embodiments

A method for manufacturing a laminated structure of the present invention is a method for manufacturing a laminated structure in which an epitaxial layer containing a crystalline compound is laminated on a crystal substrate, the method including a step of providing a compound element supply sacrificial layer containing a compound element on the crystal substrate, and a step of forming the epitaxial layer using the compound element of the compound element supply sacrificial layer. The crystalline compound is not particularly limited, and may be a known crystalline compound, but in the present invention, the crystalline compound is preferably a metal compound, and the metal of the metal compound may also be a known metal. Examples of the metal include a D-block metal in the periodic table. The compound of the metal compound may also be a known compound, and examples of the compound in the crystalline compound include oxides, nitrides, oxynitrides, sulfides, oxysulfides, borides, oxyborides, carbides, oxycarbides, boron carbides, boron nitrides, boron sulfides, carbonitrides, carbon sulfides, and carbonitrides. In the present invention, the compound of the metal compound is an oxide or a nitride, which is preferable because, for example, stress relaxation and warp reduction in heteroepitaxial growth can be made more excellent as a buffer layer, and electrical characteristics (particularly, an interface between a conductor layer and an insulating layer) can be made more excellent. Further, the crystalline compound is preferably a crystalline oxide, the compound film is preferably an oxide film, and the compound element is preferably oxygen. In the present invention, the crystalline compound is preferably a crystalline nitride, the compound film is preferably a nitride film, and the compound element is preferably nitrogen. The compound element supply sacrificial layer is preferably an oxygen supply sacrificial layer, and the epitaxial layer is preferably formed using oxygen of the oxygen supply sacrificial layer. By the manufacturing method, it is possible to easily obtain a laminated structure that includes an epitaxial film having good adhesion and crystallinity, in which the epitaxial layer is formed by incorporating a compound element in a compound element supply sacrificial layer that is provided on the crystal substrate and contains the compound element, and such a laminated structure is also included in the present invention.

The oxygen supply sacrificial layer may be a sacrificial layer that contains oxygen and in which a part or all of the layer disappears or is destroyed when oxygen atoms are taken in, and in the present invention, it is preferable that the oxide film is an oxygen supply sacrificial layer in which oxygen atoms are taken in and the oxide film itself disappears during crystal growth of the epitaxial layer. Further, in the present invention, it is preferable that the oxygen supply sacrificial layer is an oxide film provided on the crystal substrate.

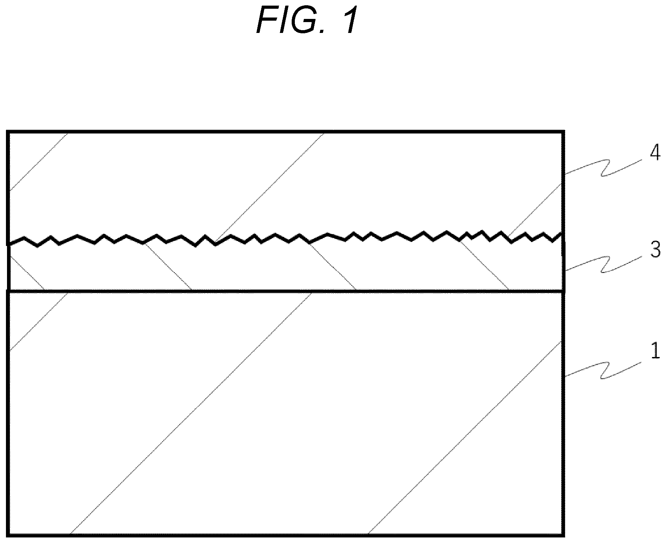

Fig. 1 shows a preferred example of the laminated structure, and in the laminated structure of Fig. 1, an epitaxial layer 3 is laminated on a crystal substrate 1 using an oxide film 2, and a second epitaxial layer 4 is further laminated on the epitaxial layer 3.

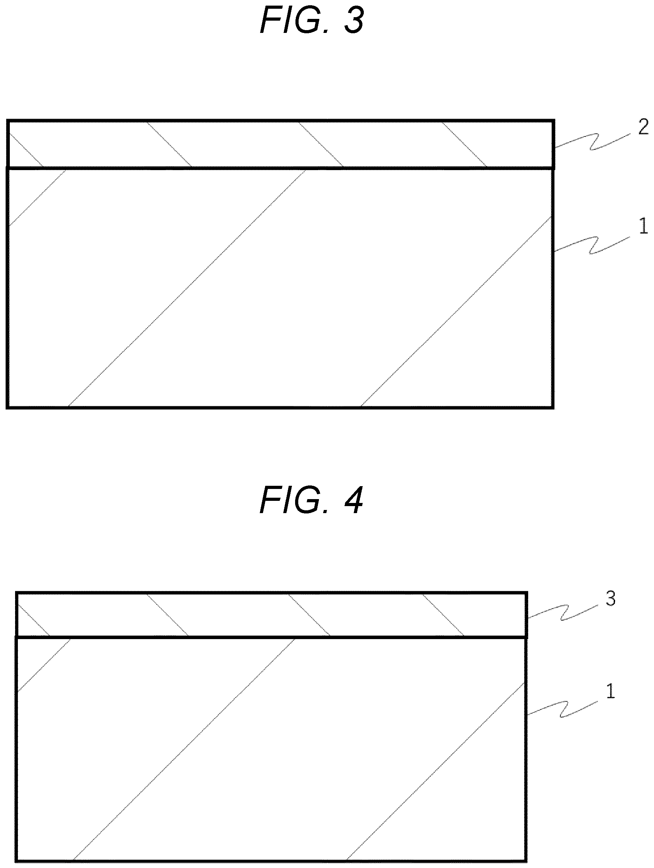

The laminated structure of the present invention can be easily manufactured, for example, by forming an oxide film 2 of a crystal substrate 1 on the crystal substrate 1 as shown in Fig. 3, and then forming an epitaxial film 3 made of a crystalline oxide on the crystal substrate 1 as shown in Fig. 4 using oxygen in the oxide film 2. In the present invention, the laminated structure may have the oxide film 2 on the crystal substrate 1, but all the oxygen in the oxide film 2 may be taken in and the oxide film 2 may disappear when the epitaxial film 3 is formed. Note that, in the present description, terms "film" and "layer" may be interchanged with each other in some cases or situations. Further, examples of oxides have been given as preferred examples of the laminated structure, but the present invention is not limited to these preferred examples, and the present invention can also be suitably applied to various compounds such as nitrides.

Hereinafter, each will be described more specifically, but the present invention is not limited to these specific examples.

The crystal substrate (hereinafter also simply referred to as a "substrate") is not particularly limited as long as the object of the present invention is not hindered, such as a substrate material, and may be a known crystal substrate. It may be an organic compound or an inorganic compound. In the present invention, it is preferable that the crystal substrate contains an inorganic compound. In the present invention, the substrate preferably is a substrate having crystals on a part or the whole of its surface, more preferably a crystal substrate having crystals on the whole or a part of its main surface on a crystal growth side, and most preferably a crystal substrate having crystals on the whole of its main surface on the crystal growth side. The crystal is not particularly limited as long as the object of the present invention is not hindered, and a crystal structure and the like are also not particularly limited, but the crystal is preferably a cubic, tetragonal, trigonal, hexagonal, orthorhombic, or monoclinic crystal, and more preferably a crystal oriented in (100) or (200). Further, the crystal substrate may have an off angle, and examples of the off angle include an off angle of 0.2° to 12.0°. Here, the "off angle" refers to an angle formed between a substrate surface and a crystal growth surface. The shape of the substrate is not particularly limited as long as it is a plate shape and serves as a support for the epitaxial film. Although the substrate may be an insulator substrate or a semiconductor substrate, in the present invention, the substrate is preferably a Si substrate, more preferably a crystalline Si substrate, and most preferably a crystalline Si substrate oriented in (100). Note that, examples of the substrate material include one kind or two or more kinds of metals that belong to group 3 to group 15 of the periodic table or oxides of these metals in addition to the Si substrate. The shape of the substrate is not particularly limited, and may be a substantially circular shape (for example, a circle, an ellipse, etc.) or a polygonal shape (for example, a triangle, a square, a rectangle, a pentagon, a hexagon, a heptagon, an octagon, a nonagon, or the like), and various shapes can be suitably used. Further, in the present invention, a large-area substrate can also be used, and the area of the epitaxial film can be increased by using such a large-area substrate.

Further, in the present invention, it is preferable that the crystal substrate has a flat surface, but it is also preferable that the crystal substrate has an uneven shape on a part or the whole of the surface because quality of the crystal growth of the epitaxial film can be further improved. It is sufficient that the crystal substrate having the uneven shape has an uneven part formed of a recess or a protrusion on a part or the whole of the surface, and the uneven part is not particularly limited as long as it is formed of a protrusion or a recess, and may be an uneven part formed of a protrusion, an uneven part formed of a recess, or an uneven part formed of a protrusion and a recess. Further, the uneven part may be formed of a regular protrusion or recess, or may be formed of an irregular protrusion or recess. In the present invention, the uneven part is preferably formed periodically, and more preferably patterned periodically and regularly. The shape of the uneven part is not particularly limited, and examples thereof include a stripe shape, a dot shape, a mesh shape, or a random shape, but in the present invention, a dot shape or a stripe shape is preferable, and a dot shape is more preferable. Further, in a case where the uneven part is periodically and regularly patterned, it is preferable that a pattern shape of the uneven part is a polygonal shape such as a triangle, a quadrangle (for example, a square, a rectangle, a trapezoid, or the like), a pentagon, or a hexagon, a circular shape, an elliptical shape, or the like. Note that, in a case where the uneven part is formed in a dot shape, a lattice shape of the dot is preferably a lattice shape such as a square lattice, an orthorhombic lattice, a triangular lattice, or a hexagonal lattice, and more preferably a lattice shape of a triangular lattice. A cross-sectional shape of the recess or protrusion of the uneven part is not particularly limited, and examples thereof include a U-shape, an angular U-shape, an inverted angular U-shape, a wave shape, and a polygonal shape such as a triangle, a quadrangle (for example, a square, a rectangle, a trapezoid, or the like), a pentagon, or a hexagon. Note that, a thickness of the crystal substrate is not particularly limited, but is preferably 50 to 2000 µm, and more preferably 100 to 1000 µm.

The oxide film is not particularly limited as long as it is an oxide film capable of incorporating oxygen atoms into the epitaxial film as the oxygen supply sacrificial layer, and usually contains an oxidizing material. The oxidizing material is not particularly limited as long as the object of the present invention is not hindered, and may be a known oxidizing material. Examples of the oxidizing material include a metal or metalloid oxides. In the present invention, the oxide film preferably contains an oxidizing material of the crystal substrate, and examples of such an oxide film include a thermal oxide film of the crystal substrate and a natural oxide film. Further, the oxide film may be patterned, for example, may be patterned in a stripe shape, a dot shape, a mesh shape, or a random shape. Note that, the film thickness of the oxide film is not particularly limited, but is preferably more than 1 nm and less than 100 nm.

The epitaxial layer is not particularly limited as long as it includes an epitaxial film in which oxygen atoms in the oxide film are incorporated. Note that, the "epitaxial film in which oxygen atoms in the oxide film are incorporated" means that oxygen atoms in the oxide film are taken away by the epitaxial film in the crystal growth of the epitaxial film. The epitaxial film is not particularly limited as long as it is an epitaxial film that is crystal-grown by incorporating oxygen atoms in the oxide film, but in the present invention, it preferably contains a metal or a metal oxide. Preferable examples of the metal include one kind or two or more kinds of metals that belong to the periodic table d block. Preferable examples of the metal oxide include oxides of one kind or two or more kinds of metals that belong to the periodic table d block. In the present invention, it is preferable that the epitaxial film contains a dielectric. Further, in the present invention, it is preferable that the epitaxial film contains a neutron-absorbing material. The neutron-absorbing material may be a known neutron-absorbing material, and in the present invention, by taking in oxygen of the oxide film using such a neutron-absorbing material, it is possible to improve the adhesion, the crystallinity, characteristics of functional films, and the like. Note that, preferable examples of the neutron-absorbing material include hafnium (Hf). Further, the epitaxial layer may be composed of one kind or two or more kinds of epitaxial films, and in the present invention, it is preferable that the epitaxial layer includes two or more kinds of the epitaxial films. More specifically, for example, it is preferable that a second epitaxial film having a composition different from that of the epitaxial film is laminated on the epitaxial film directly or via another layer. By laminating in this manner, at the interface between the epitaxial layer and the second epitaxial layer, at the interface between the epitaxial layer (hereinafter also referred to as a "first epitaxial layer") and the second epitaxial layer, the first epitaxial layer can be regularly transformed so as to be substantially the same as a lattice constant of the second epitaxial layer. Preferable examples of an aspect of the regular transformation include a transformation in which a shape is deformed into a peak-valley structure, and in the present invention, it is preferable that angles formed by adjacent apexes and bottom points of the peak-valley structure are different from each other, and it is more preferable that the angles are each within a range of 30° to 45°. Here, the epitaxial layer usually has a first crystal plane and a second crystal plane, but a lattice constant difference between the first crystal plane and the second crystal plane may be generated by the transformation, and thus it is preferable that the lattice constant difference between the first crystal plane and the second crystal plane is within a range of 0.1% to 20%. In the present invention, since the first crystal plane can be made substantially the same as the lattice constant of the second epitaxial film, it is possible to easily realize the lattice constant difference between the first epitaxial layer and the second epitaxial layer within the range of 0.1% to 20%.

Further, in the present invention, it is more preferable that the epitaxial film is a dielectric and the second epitaxial film is an electrode. By using the second epitaxial layer as an electrode, not only the adhesion, the crystallinity, and the like at the interface can be further improved, but also, for example, characteristics of the element can be further improved. Further, according to the present invention, in a case where the second epitaxial layer is made of a single crystal film of a conductive metal, a defect-free film having a large area can be easily obtained, and not only a function as an electrode but also the characteristics of the element and the like can be further improved. The conductive metal is not particularly limited as long as the object of the present invention is not hindered, and examples thereof include gold, silver, platinum, palladium, silver palladium, copper, nickel, and alloys thereof, but in the present invention, platinum is preferably contained. Note that, in the present invention, according to the manufacturing method, preferably, a defect-free single crystal film can be obtained as an electrode in an area of 100 nm² or more, and more preferably, a defect-free single crystal film can be easily obtained in an area of 1000 nm² or more. Further, a single crystal film having a thickness of preferably 100 nm or more can be easily obtained as an electrode.

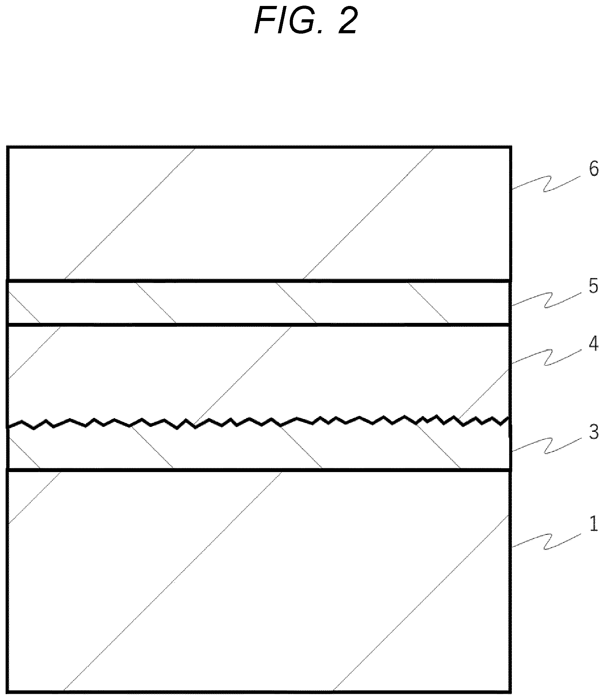

Further, in the present invention, it is preferable that a third epitaxial film and/or a fourth epitaxial film having a composition different from those of the epitaxial film and the second epitaxial film be further laminated on the second epitaxial film directly or via another layer. Fig. 2 shows a preferred example of a laminated structure in which the third epitaxial layer 5 and the fourth epitaxial layer 6 are laminated on the second epitaxial layer 4. In the laminated structure of Fig. 2, a first epitaxial layer 3 is laminated on a crystal substrate 1 using an oxide film, the second epitaxial layer 4 is further laminated on the first epitaxial layer 3, the third epitaxial layer 5 is laminated on the second epitaxial layer 4, and the fourth epitaxial layer 6 is laminated on the third epitaxial layer 5. Note that, the third epitaxial film in the third epitaxial layer is preferably a dielectric, a semiconductor, or a conductor, more preferably a dielectric, and most preferably a piezoelectric body. Further, the fourth epitaxial film in the fourth epitaxial layer is preferably a dielectric, a semiconductor, or a conductor, more preferably a dielectric, and most preferably a piezoelectric body. The film thickness of each of the epitaxial films is not particularly limited, but is preferably 10 nm to 1000 µm, and more preferably 10 nm to 100 µm.

The laminated structure can be easily obtained by performing the lamination by forming an epitaxial film using oxygen atoms in the oxide film at 350°C to 700°C in a method for manufacturing a laminated structure in which an epitaxial layer is laminated on a crystal substrate with at least an oxide film interposed therebetween. When the temperature is in the range of 350°C to 700°C, oxygen atoms in the oxide film can be easily taken in the epitaxial film to cause crystal growth.

In the present invention, it is preferable to form the epitaxial film using oxygen gas after the lamination is performed using oxygen atoms in the oxide film, and by forming the film in this manner, a film formation rate and the like become more excellent. Further, by forming a film in this manner, it is possible to easily obtain a laminated structure in which an epitaxial layer is laminated on a crystal substrate, the laminated structure including an amorphous thin film containing a constituent metal of the epitaxial layer and/or the crystal substrate and/or one or more embedded layers that are embedded in a part of the crystal substrate and contain the constituent metal, between the crystal substrate and the epitaxial layer. In the present invention, it is preferable that the laminated structure has both the amorphous layer and the embedded layer because functionality and the like of the epitaxial film can be further improved. Further, it is preferable that the amorphous layer and the embedded layer each contain a constituent metal of the epitaxial layer because the crystallinity of the epitaxial film and the like become more excellent. Further, in the present invention, it is preferable that the constituent metal contains Hf because stress relaxation and the like are further promoted, and stress relaxation and the like in multiple stages can also be realized. Further, in the present invention, it is preferable that the amorphous thin film has a film thickness of 1 nm to 10 nm because the crystallinity and the like of the epitaxial film can be further improved, and such an amorphous thin film having a preferable film thickness can be easily obtained by the preferable manufacturing method of the present invention. Further, in the present invention, it is preferable that the shape of the embedded layer has a substantially inverted triangular cross-sectional shape because the functionality of the epitaxial film can be further improved. Note that, these preferred laminated structures can be easily obtained by appropriately adjusting the film thickness of the oxide film, introduction timing of the oxygen gas, and the like.

As a laminating means used in the lamination, usually, a film forming means of the epitaxial film is suitably used, and the film forming means may be a known film forming means. In the present invention, the film forming means is preferably vapor deposition or sputtering, and more preferably vapor deposition.

The laminated structure obtained as described above is suitably used for an electronic device according to a conventional method. For example, various electronic devices can be configured by connecting the laminated structure to a power supply or an electric/electronic circuit as a piezoelectric element, and mounting or packaging the laminated structure on a circuit board. In the present invention, the electronic device is preferably a piezoelectric device, and can be used as a piezoelectric device in an electronic apparatus such as an inkjet printer head, a microactuator, a gyroscope, or a motion sensor. Further, for example, when an amplifier and a rectifier circuit are connected and packaged, the electronic device can be used for various sensors such as a magnetic sensor. Further, the electronic device can also be applied to a memory driven at a constant voltage, and for example, when a power storage element and a rectified power management circuit are connected, the electronic device becomes an energy conversion device (an energy harvester) that generates power from an external magnetic field or vibration. Note that, the energy conversion device is incorporated into and used in a power supply system, a wearable terminal (earbuds/a hearable device, a smartwatch, smart glasses (eyeglasses), smart contact lenses, a cochlear implant, a cardiac pacemaker, etc.), and the like. In the present invention, the laminated structure is preferably used, for example, in smart glasses, AR headsets, an MEMS mirror for an LiDAR system, a piezoelectric MEMS ultrasonic transducer (PMUT) for advanced medical care, a piezo head for commercial and industrial 3D printers, and the like.

The electronic device is suitably used for an electronic apparatus according to a conventional method. The electronic apparatus can be applied to various electronic apparatus other than the electronic apparatus described above, and more specifically, preferable examples thereof include a liquid discharge head, a liquid discharge device, a vibration wave motor, an optical equipment, a vibration device, an imaging device, a piezoelectric acoustic component, a sound reproduction equipment having the piezoelectric acoustic component, a voice recording equipment, a mobile phone, and various information terminals.

Further, the electronic apparatus is also applied to a system according to a conventional method, and examples of such a system include a sensor system.

### Examples

### (Example 1)

A crystal growth surface side of the Si substrate (100) was treated by RIE and heated in the presence of oxygen to form a thermal oxide film, and then a metal as a vapor deposition source and oxygen in the oxide film on the Si substrate were thermally reacted by a vapor deposition method without using oxygen to form a single crystal of a crystalline metal oxide on the Si substrate. Then, oxygen was flowed, the temperature was lowered, and the pressure was increased to form a single crystal film of a crystalline metal oxide by a vapor deposition method. Note that, conditions of the vapor deposition method during this film formation were as follows.
Vapor deposition source: Hf, Zr
Voltage: 3.5 to 4.75 V
Pressure: 3 × 10⁻² to 6 × 10⁻² Pa
Substrate temperature: 450 to 700°C

Next, a metal film of platinum (Pt) was formed as a conductive film on the single crystal film of the crystalline metal oxide by a sputtering method. The conditions at this time are shown below.

Apparatus: Sputtering apparatus QAM-4 manufactured by ULVAC, Inc.
Pressure: 1.20 × 10⁻¹ Pa
Target: Pt
Power: 100 W (DC)
Thickness: 100 nm
Substrate temperature: 450 to 600°C

Next, an SRO film was formed on the conductive film by a sputtering method. The conditions at this time are shown below.

Apparatus: Sputtering apparatus QAM-4 manufactured by ULVAC, Inc.
Power: 150 W (RF)
Gas: Ar
Pressure: 1.8 Pa
Substrate temperature: 600°C
Thickness: 20 nm

Next, a Pb(Zr_{0.52}Ti_{0.48})O₃ film (PZT film) was formed as a piezoelectric film on the SRO film by a coating method. The conditions at this time are shown below.

Lead acetate was used as a raw material for Pb, zirconium nitrate was used as a raw material for Zr, and titanium isopropoxide was used as a raw material for Ti. Further, raw materials for Pb, Zr, and Ti were mixed so as to have a composition ratio of Pb : Zr : Ti = 100 + δ : 52 : 48, pure water was used as a solvent in consideration of solubility of the raw materials, and acetic acid was added to control hydrolysis. Furthermore, for viscosity adjustment, ethanol (0.5 to 3.0 mol with respect to 1 mol of PZT) in which polyvinylpyrrolidone powder was mixed and dissolved was added and used. Finally, an appropriate amount of 2n butoxyethanol was mixed for adjusting wettability during application to prepare a sol-gel solution as a raw material solution.

Next, the prepared sol-gel solution was dropped onto the substrate, and rotated at 2000 rpm for one minute, and the sol-gel solution was spin-coated (applied) on the substrate to form a film containing a precursor. Then, the substrate was placed on a hot plate at a temperature of 150°C, and the substrate was further placed on a hot plate at a temperature of 350°C to evaporate the solvent and dry the film. This step was repeated five times to laminate five layers under the same conditions, and then heat treatment was performed at 650°C for three minutes in an oxygen (O₂) atmosphere to oxidize and crystallize the precursor. The above process was repeated ten times to prepare a Pb(Zr_{0.52}Ti_{0.48})O₃ film (PZT film) . A total film thickness at this time was 10 µm.

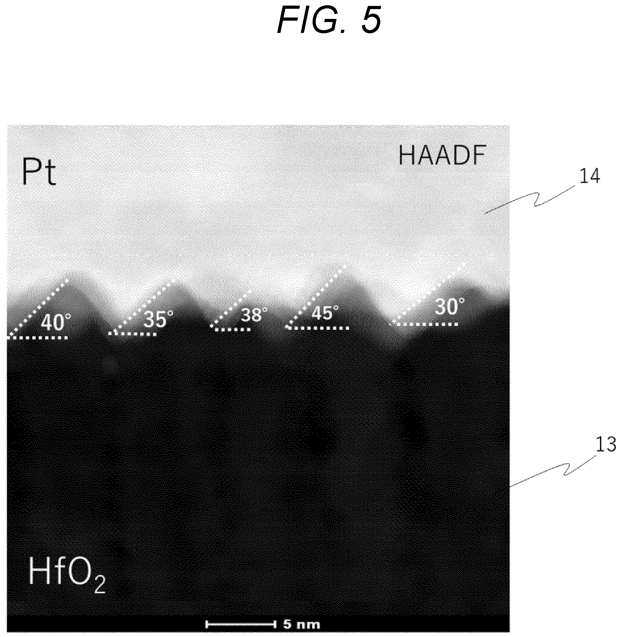

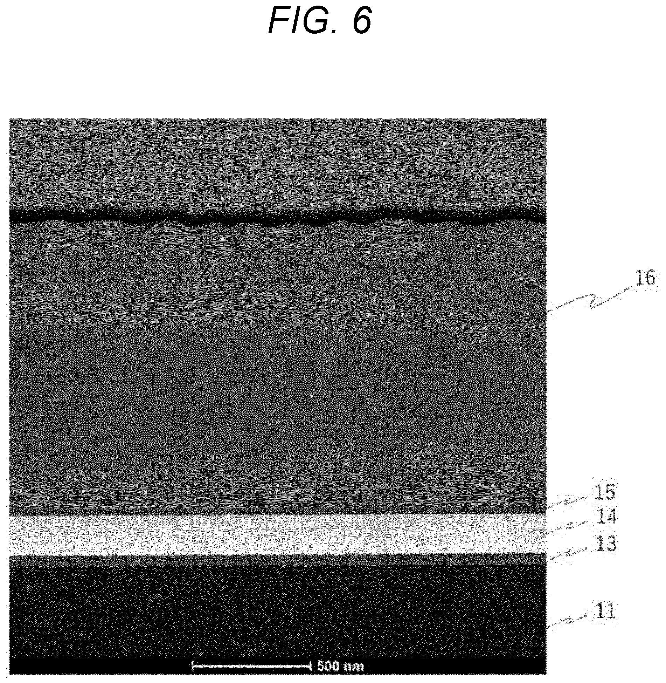

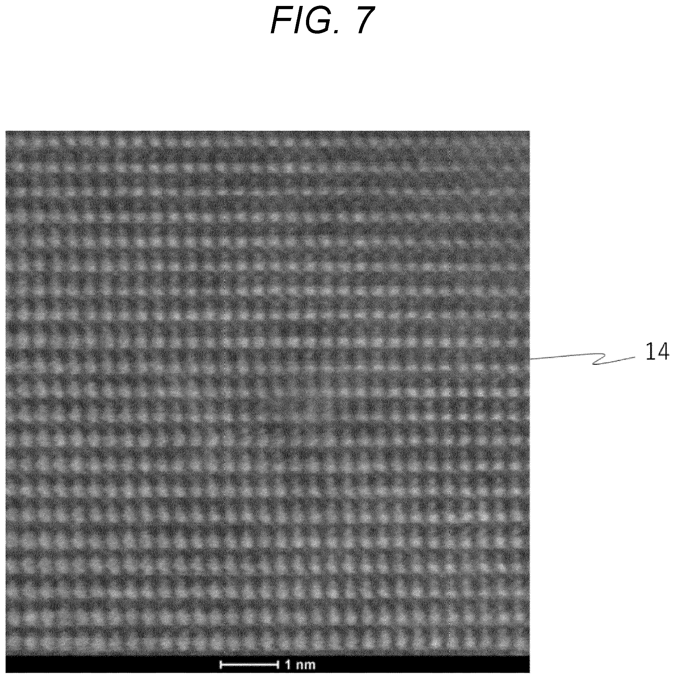

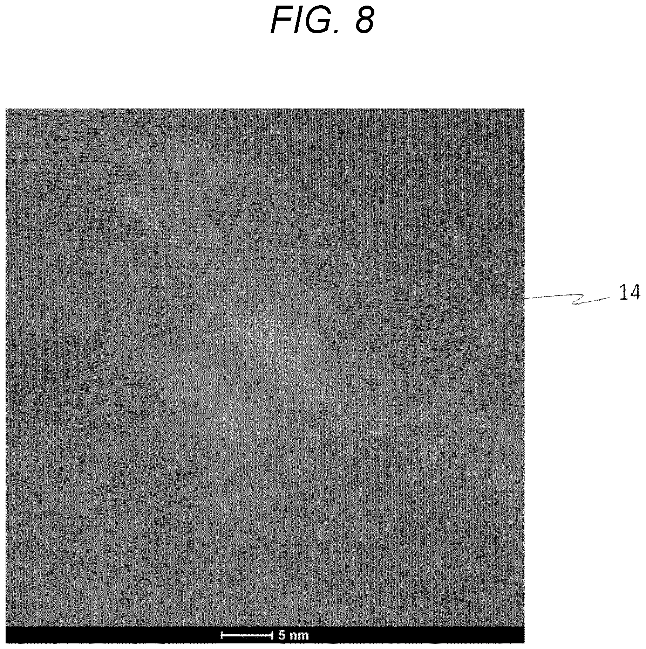

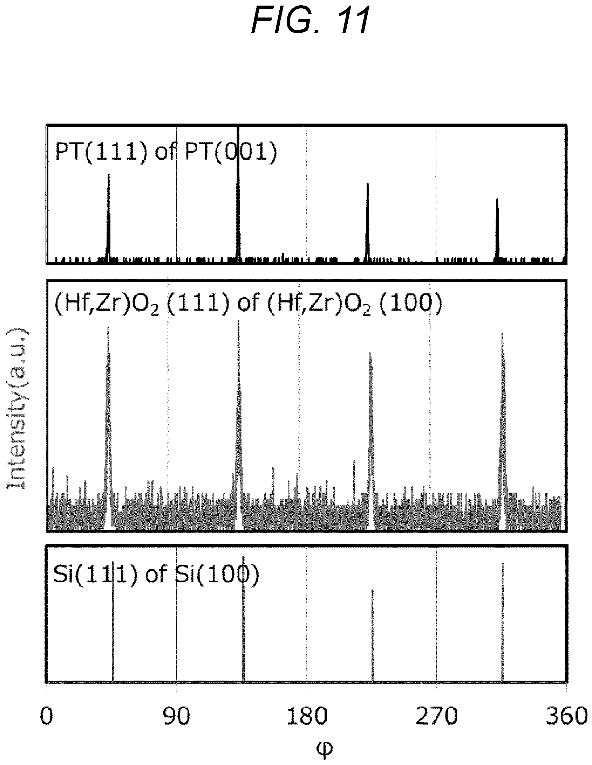

The obtained laminated structure was a laminated structure including an epitaxial film having good adhesion and crystallinity. Further, cross-sectional STEM images of the obtained laminated structure are shown in Figs. 5 and 6. It can be seen from Fig. 6 that a very high-quality laminated structure is obtained, and in particular, in Fig. 5, it can be seen that a regular peak-valley structure is provided at the interface between the single crystal film of the crystalline metal oxide and the conductive film, and the angles formed by the apexes and the bottom points adjacent to each other of the peak-valley structures are different within the range of 30° to 45°. Further, an X-ray crystal lattice image of the conductive film is shown in Figs. 7 and 8. It can be seen from Figs. 7 and 8 that the conductive film has a large area with no defects, and exhibits excellent effects in electrode characteristics and piezoelectric characteristics of a piezoelectric film laminated thereon. Conventionally, it has been difficult for a piezoelectric film formed by spin coating to exhibit piezoelectric characteristics, but in this example, a piezoelectric film (PZT film) formed by spin coating has good piezoelectric characteristics. Further, crystals of the crystal substrate of the laminated structure, the single crystal film of the crystalline metal oxide, and the conductive film were measured using an X-ray diffractometer. Fig. 11 shows XPS measurement results. As is clear from Fig. 11, a (Hf,Zr)O₂ film and a Pt single crystal film having good crystallinity were formed on a Si crystal substrate.

### (Example 2)

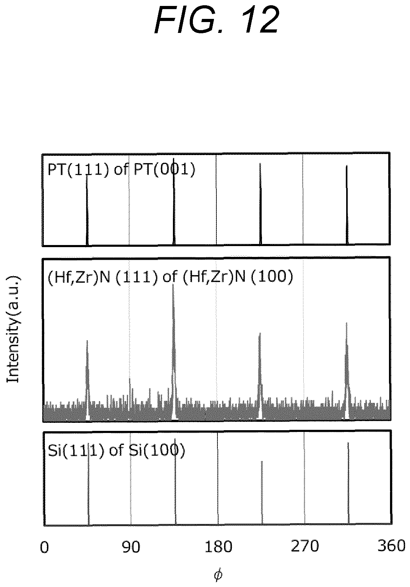

A metal film of platinum (Pt) was formed as a conductive film on a single crystal film of a crystalline metal nitride in the same manner as in Example 1 except that nitrogen gas was used instead of oxygen gas. Then, the crystal substrate of the laminated structure, the single crystal film of the crystalline metal nitride, and the conductive film were each measured using an X-ray diffractometer. Fig. 12 shows XPS measurement results. As is clear from Fig. 12, a (Hf,Zr)N film and a Pt single crystal film having good crystallinity were formed on the Si crystal substrate. Note that, when measured by a four-terminal method, the obtained single crystal film of the crystalline metal nitride had good conductivity.

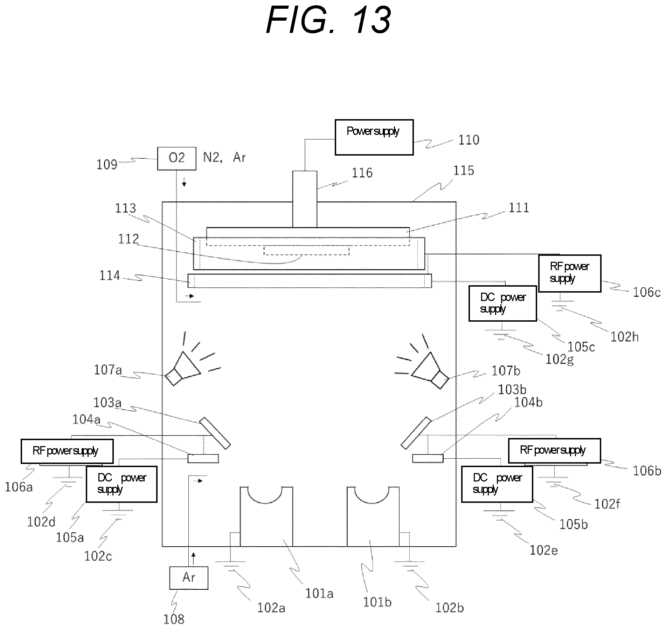

A vapor deposition film forming apparatus used in Example 1 is shown in Fig. 13. The film forming apparatus of Fig. 13 includes at least metal sources 101a to 101b in a crucible, earths 102a to 102h, ICP electrodes 103a to 103b, cut filters 104a to 104b, DC power supplies 105a to 105b, RF power supplies 106a to 106b, lamps 107a to 107b, an Ar source 108, a reactive gas source 109, a power supply 110, a substrate holder 111, a substrate 112, a cut filter 113, an ICP ring 114, a vacuum chamber 115, and a rotating shaft 116. Note that, the ICP electrodes 103a to 103b in Fig. 13 have a substantially concave surface shape or a parabolic shape curved toward the center of the substrate 112.

As shown in Fig. 13, the substrate 112 is locked onto the substrate holder 111. Next, the rotating shaft 116 is rotated using power supply 110 and a rotating mechanism (not illustrated) to rotate the substrate 112. Further, the substrate 112 is heated by the lamps 107a to 107b, and an inside of the vacuum chamber 115 is evacuated to a vacuum or reduced pressure by a vacuum pump (not illustrated). Thereafter, Ar gas is introduced from the Ar source 108 into the vacuum chamber 115, and argon plasma is formed on the substrate 112 using the DC power supplies 105a to 105b, the RF power supplies 106a to 106b, the ICP electrodes 103a to 103b, the cut filters 104a to 104b, and the earths 102a to 102h, thereby cleaning the surface of the substrate 112.

Ar gas is introduced into the vacuum chamber 115, and a reactive gas is introduced using the reactive gas source 109. At this time, by alternately repeating on and off of the lamps 107a to 107b as lamp heaters, a crystal growth film with higher quality can be formed.

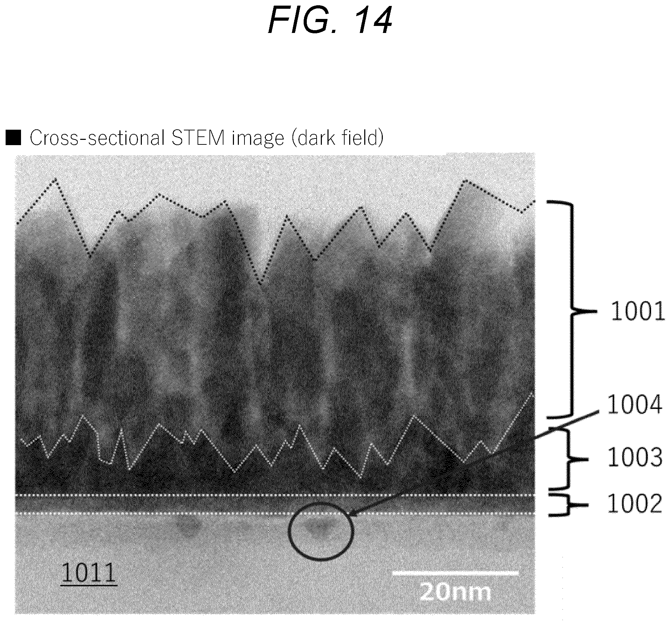

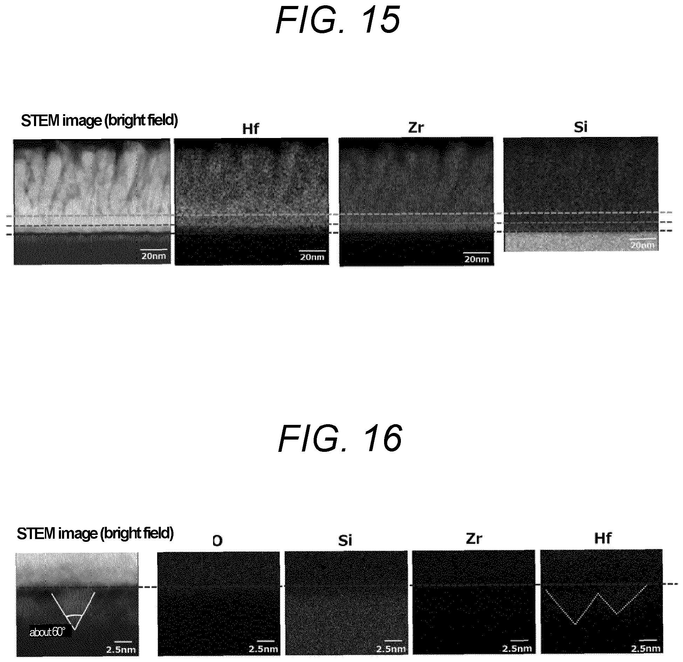

The laminated structure obtained in the same manner as in Example 1 was subjected to STEM analysis. The results are shown in Figs. 14 to 16. It can be seen from Fig. 14 that an embedded layer 1004 is formed between a crystal substrate 1011 and an epitaxial layer 1001, and further amorphous layers 1002 and 1003 are formed. Further, it can be seen from Fig. 15 that the first amorphous layer 1002 on the crystal substrate 1011 contains Si of the crystal substrate and Zr, which is a constituent metal of the epitaxial layer 1001. Further, it is found that the second amorphous layer contains Si of the crystal substrate and Hf and Zr, which are constituent metals of the epitaxial layer 1001. Further, it can be seen from Fig. 16 that the embedded layer 1004 has a substantially inverted triangular cross-sectional shape and is an oxide containing Hf and Si.

### (Application examples)

Hereinafter, application examples of the obtained laminated structure will be described more specifically with reference to the drawings, but the present invention is not limited to these application examples. Note that, in the present invention, unless otherwise specified, a piezoelectric device or the like can be manufactured from the laminated structure using known means.

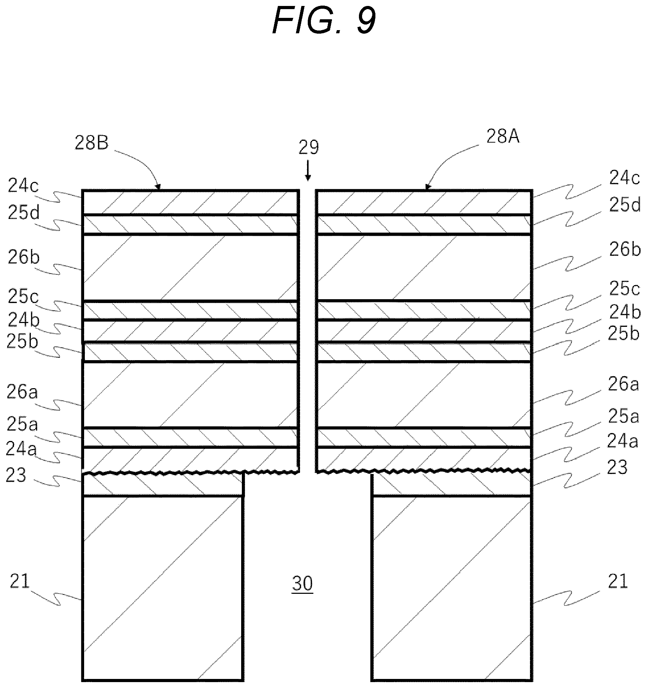

Fig. 9 shows an embodiment of an acoustic MEMS transducer constituting an MEMS microphone in which the laminated structure is suitably used in the present invention. Note that, the MEMS transducer can constitute an acoustic emission device (for example, a speaker or the like).

The MEMS microphone constituted by the acoustic MEMS transducer of Fig. 9 shows a cantilever type MEMS microphone and includes a Si substrate 21 having two cantilever beams 28A and 28B and a cavity 30. Each cantilever beam 28A and 28B is fixed to the substrate 21 at its respective end, and a gap 9 is provided between the cantilever beams 8A and 8B. Note that, the cantilever beams 8A and 8B are formed by, for example, a laminated structure including a plurality of piezoelectric layers (PZT films) 26a and 26b, and are alternately arranged with a plurality of electrode layers, that is, Pt films 24a, 24b, and 24c and SRO films 25a, 25b, 25c, and 25d. A dielectric layer (a single crystal film of a crystalline oxide) 23 electrically insulates the cantilever beams 8A and 8B from the crystal substrate 21. In Fig. 9, a neutron-absorbing material (for example, HfO₂ or a mixed crystal thereof) is used for the dielectric layer (the single crystal film of the crystalline oxide) 23, and is excellent in adhesion to the Si substrate and crystallinity, and further excellent in piezoelectric characteristics and durability as compared with a case where SiO₂, SiN, or the like is used.

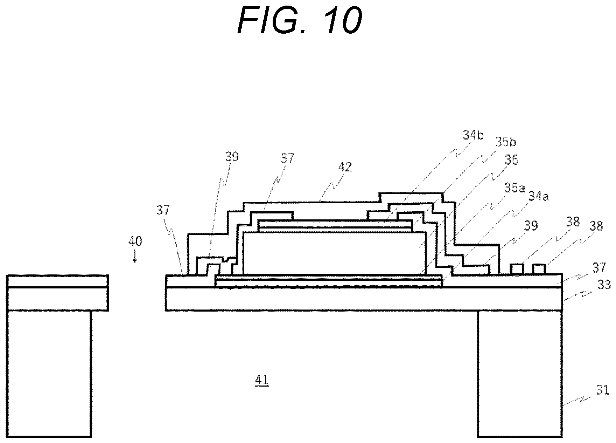

Fig. 10 shows an example of application to a fluid discharge apparatus that can be used in printing applications, particularly in an aspect of an inkjet printhead, in which the laminated structure is suitably used in the present invention, and specifically shows a cross-sectional view of a part of a wafer including a piezoelectric actuator that includes Pt films 34a and 34b and SRO films 35a and 35b as electrode layers and includes a PZT film 36 as a piezoelectric film. The wafer of Fig. 10 includes a chamber 41 for containing a fluid in addition to the piezoelectric actuator. The chamber 41 is configured to take in a fluid from a tank (not illustrated) through a flow channel 40. Further, the wafer in Fig. 10 includes a Si substrate 31, and a dielectric layer (a single crystal film of a crystalline oxide) 33 is provided thereon as a first epitaxial layer and faces the chamber 41. In Fig. 10, a neutron-absorbing material (for example, HfO₂ or a mixed crystal thereof) is used for the dielectric layer (the single crystal film of the crystalline oxide) 23, and is excellent in adhesion to the Si substrate and crystallinity, and further excellent in piezoelectric characteristics and durability as compared with a case where SiO₂, SiN, or the like is used. Note that, the single crystal film 33 of the crystalline oxide has, for example, a quadrangular shape in a top view (not illustrated), and such a shape may be, for example, any of a square, a rectangle, a rectangle with rounded corners, a parallelogram, and the like.

The Pt film 34a, the SRO film 35a, the piezoelectric film (PZT film) 36, the SRO film 35b, and the Pt film 34b are sequentially laminated on the single crystal film 33 of the crystalline oxide to constitute a piezoelectric actuator. Further, the piezoelectric actuator further includes electrodes 34a and 35a, the piezoelectric film 36, and an insulating film 37 extending on electrodes 34b and 35b. The insulating film 37 includes a dielectric material used for electrical insulation, but such a dielectric material may be a known dielectric material, for example, a SiO₂ layer, a SiN layer, or an Al₂O₃ layer. Note that, the thickness of the insulating layer including the insulating film as a constituent material is not particularly limited, but is preferably a thickness between about 10 nm and about 10 um. Further, a conductive path 39 is provided on the insulating layer (insulating film) 37 and is in contact with the electrodes 34a and 35a and the electrodes 34b and 35b, respectively, to enable selective access during use. Note that, the constituent material of the conductive path may be a known conductive material, and preferred examples of such a conductive material include aluminum (Al). Further, a passivation layer 42 is provided on the insulating layer 37, the electrodes 34b and 35b, and the conductive path 39. The passivation layer 42 may be made of a dielectric material used for passivation of the piezoelectric actuator, and such a dielectric material is not particularly limited, and may be a known dielectric material. Preferable examples of the dielectric material include SiN or SION (silicon oxynitrate). The thickness of the passivation layer is not particularly limited, but is preferably a thickness between about 0.1 um and about 3 um. Further, a conductive pad 38 is similarly provided along the piezoelectric actuator and is electrically connected to the conductive path 39. Note that, the passivation layer 42 functions as a barrier layer that protects the piezoelectric body from humidity or the like.

### Industrial Applicability

The laminated structure of the present invention is suitably used as, for example, an electronic device such as a piezoelectric device, and is suitably used for an electronic apparatus, a sensor system, and the like.

### Reference Signs List

1 crystal substrate
2 oxide film
3 (first) epitaxial layer
4 second epitaxial layer
5 third epitaxial layer
6 fourth epitaxial layer
11 Si substrate
13 single crystal film of crystalline oxide
14 conductive film
15 SRO film
16 PZT film
21 crystal substrate (Si substrate)
23 (first) epitaxial layer (single crystal film of crystalline oxide)
24a second epitaxial layer (Pt film)
24b sixth epitaxial layer (Pt film)
24c tenth epitaxial layer (Pt film)
25a third epitaxial layer (SRO film)
25b fifth epitaxial layer (SRO film)
25c seventh epitaxial layer (SRO film)
25d ninth epitaxial layer (SRO film)
26a fourth epitaxial layer (PZT film)
26b eighth epitaxial layer (PZT film)
28A cantilever beam
28B cantilever beam
29 gap
30 cavity
31 crystal substrate (Si substrate)
33 (first) epitaxial layer (single crystal film of crystalline oxide)
34a second epitaxial layer (Pt film)
34b sixth epitaxial layer (Pt film)
35a third epitaxial layer (SRO film)
35b fifth epitaxial layer (SRO film)
36 fourth epitaxial layer (PZT film)
37 insulating film
38 conductive pad
39 conduction path
40 flow channel
41 chamber
42 passivation layer
101a to 101b metal source
102a to 102j earth
103a to 103b ICP electrode
104a to 104b cut filter
105a to 105b DC power supply
106a to 106b RF power supply
107a to 107b lamp
108 Ar source
109 reactive gas source
110 power supply
111 substrate holder
112 substrate
113 cut filter
114 ICP ring
115 vacuum chamber
116 rotating shaft
1001 epitaxial layer
1002 first amorphous layer
1003 second amorphous layer
1004 embedded layer
1011 substrate

## Claims

1. A method for manufacturing a laminated structure in which an epitaxial layer containing a crystalline compound is laminated on a crystal substrate, the manufacturing method comprising: a step of providing a compound element supply sacrificial layer containing a compound element on the crystal substrate; and a step of forming the epitaxial layer using the compound element of the compound element supply sacrificial layer.

2. The manufacturing method according to claim 1, wherein after the compound element is used, a compound element gas is introduced to form the epitaxial layer in the presence of the compound element gas.

3. The manufacturing method according to claim 1 or 2, wherein the lamination is performed by vapor deposition or sputtering.

4. The manufacturing method according to claim 1 or 2, wherein the lamination is performed by vapor deposition.

5. The manufacturing method according to any one of claims 1 to 4, wherein the compound element supply sacrificial layer is a compound film provided on the crystal substrate.

6. A laminated structure in which an epitaxial layer is laminated on a crystal substrate, wherein the epitaxial layer is formed by incorporating a compound element in a compound element supply sacrificial layer that is provided on the crystal substrate and contains the compound element.

7. The laminated structure according to claim 6, wherein the crystal substrate is a crystalline Si substrate.

8. The laminated structure according to claim 6 or 7, wherein the compound element supply sacrificial layer includes a compound film.

9. The laminated structure according to claim 8, wherein a film thickness of the compound film is more than 1 nm and less than 100 nm.

10. The laminated structure according to any one of claims 6 to 9, wherein the epitaxial layer contains a metal.

11. The laminated structure according to claim 10, wherein the metal includes a periodic table d-block metal.

12. The laminated structure according to any one of claims 6 to 9, wherein the epitaxial layer contains a metal compound.

13. The laminated structure according to any one of claims 6 to 9, wherein the epitaxial layer includes a dielectric.

14. The laminated structure according to any one of claims 6 to 13, wherein a second epitaxial layer having a composition different from that of the epitaxial layer is further laminated on the epitaxial layer directly or via another layer.

15. The laminated structure according to claim 14, wherein the epitaxial layer includes a dielectric, and the second epitaxial layer includes a single crystal film of a conductive metal.

16. The laminated structure according to claim 14 or 15, wherein a third epitaxial layer having a composition different from those of the epitaxial layer and the second epitaxial layer is further laminated on the second epitaxial layer directly or via another layer.

17. The laminated structure according to claim 16, wherein the third epitaxial layer includes a dielectric, a semiconductor, or a conductor.

18. The laminated structure according to claim 16, wherein the third epitaxial layer includes a dielectric.

19. The laminated structure according to claim 16, wherein the third epitaxial layer includes a piezoelectric body.

20. A piezoelectric element comprising a laminated structure, wherein the laminated structure is the laminated structure according to any one of claims 6 to 19.

21. A method for manufacturing a piezoelectric element that uses a laminated structure, wherein the laminated structure is the laminated structure according to any one of claims 6 to 19.

22. An electronic device comprising a laminated structure, wherein the laminated structure is the laminated structure according to any one of claims 1 to 14.

23. The electronic device according to claim 22, wherein the electronic device is a piezoelectric device.

24. A method for manufacturing an electronic device that uses a laminated structure, wherein the laminated structure is the laminated structure according to any one of claims 6 to 19.

25. An electronic apparatus comprising an electronic device, wherein the electronic device is the electronic device according to claim 22 or 23.

26. A method for manufacturing an electronic apparatus using a laminated structure or an electronic device, wherein the laminated structure is the laminated structure according to any one of claims 6 to 19, and the electronic device is the electronic device according to claim 22 or 23.

27. A system comprising an electronic apparatus, wherein the electronic apparatus is the electronic apparatus according to claim 25.

28. A laminated structure in which an epitaxial layer is laminated on a crystal substrate, the laminated structure comprising: an amorphous thin film containing a constituent metal of the epitaxial layer and/or the crystal substrate and/or one or more embedded layers that are embedded in a part of the crystal substrate and contain the constituent metal, between the crystal substrate and the epitaxial layer.

29. The laminated structure according to claim 28, comprising: an amorphous thin film containing a constituent metal of the epitaxial layer and/or one or more embedded layers that are embedded in a part of the crystal substrate and contain a constituent metal of the epitaxial layer, between the crystal substrate and the epitaxial layer.

30. The laminated structure according to claim 28, comprising: an amorphous thin film containing a constituent metal of the epitaxial layer and/or the crystal substrate; and one or more embedded layers that are embedded in a part of the crystal substrate and contain the constituent metal, between the crystal substrate and the epitaxial layer.

31. The laminated structure according to any one of claims 28 to 30, wherein the constituent metal contains Hf.

32. The laminated structure according to any one of claims 28 to 31, wherein the amorphous thin film has a film thickness of 1 nm to 10 nm.

33. The laminated structure according to any one of claims 28 to 32, wherein the shape of the embedded layer has a substantially inverted triangular cross-sectional shape.

34. An electronic device, an electronic apparatus, or a system comprising a laminated structure, wherein the laminated structure is the laminated structure according to any one of claims 28 to 33.
